# EUROPEAN PATENT APPLICATION

(11) **EP 1 021 070 A1**
(43) Date of publication of application: **19.07.2000**
(21) Application number: 00300197.1
(22) Date of filing: 12.01.2000
(51) Int. Cl.: H05B 33/04

(54) **Organic electroluminescent device**

(30) Priority: 14.01.1999 JP 845699
(71) Applicant: TDK Corporation, Chuo-ku, Tokyo 103-8272 (JP)
(72) Inventor: Endo, Hiroyuki, c/o TDK Corporation, Tokyo 103-8272 (JP); Onitsuka, Osamu, c/o TDK Corporation, Tokyo 103-8272 (JP); Ebisawa, Akira, c/o TDK Corporation, Tokyo 103-8272 (JP); Kawashima, Masayuki, c/o TDK Corporation, Tokyo 103-8272 (JP); Hayakawa, Toshio, c/o TDK Corporation, Tokyo 103-8272 (JP)
(74) Representative: Wise, Stephen James

(57) **Abstract**

The invention provides an organic electroluminescent device comprising a substrate (1), an organic electroluminescent structure (3) formed on the substrate and a sealing sheet (2) for sealing up the organic electroluminescent structure. The sealing sheet (2) has a light transmittance of 80% or greater with respect to at least one of 355-nm wavelength light, 532-nm wavelength light and 1,064-nm wavelength light. A desiccant is located on the inside of a junction for fixing the sealing sheet (2) onto the substrate (1) and on the outside of a space in which the organic electroluminescent structure (3) is formed.

## Description

### BACKGROUND ART OF THE INVENTION

The present invention relates generally to an organic electroluminescent (EL) device using an organic compound, and more particularly to a sealing structure for providing protection of an organic EL structure stacked on a substrate.

The organic EL device is a device comprising a positive electrode and a negative electrode, at least one of which is generally transparent, and an organic layer having a light emitting function (hereinafter called shortly the organic layer) interleaved between them, so that light of a color corresponding to the material forming the organic layer can be emitted upon a direct current passed between the electrodes. In other words, the organic EL device emits light on the same principles as a so-called LED (light emitting device) made up of an inorganic semiconductor.

A display system using an organic EL device has some advantages over a liquid crystal display that is a flat panel display current in vogue, as indicated below.
(1) The organic EL device emits light spontaneously and so ensures a wide field angle.
(2) A thin type display having a thickness of about 2 to 3 mm can be easily fabricated.
(3) The organic EL device can emit natural colors because of no need of using any polarizing plate.
(4) Clearer displays than ever before can be obtained because of a wide dynamic range for brightness.
(5) The organic EL device can operate over a wide temperature range.
(6) The organic EL device can present a display of dynamic images because its response speed is faster than that of a liquid crystal display by three orders of magnitude or greater.

However, the fabrication of such an organic EL display has difficulty different from that with the fabrication of a liquid crystal display.

It is known that one factor of this difficulty is deterioration of the organic EL device due to moisture. Exposure of the organic EL device to moisture, for instance, causes a light emitting layer to peel off electrode layers, or materials forming part thereof to degenerate. This results in another problem that non-light emission spots called dark spots occur or any consistent light emission cannot be kept due to a light emitting area decrease.

One approach known to solve this problem is to fix an airtight case, a sealing layer or the like closely on a substrate to cover an organic EL multilayer structure, thereby shielding it from the outside, as typically set forth in JP-A's 5-36475, 5-89959 and 7-169567.

Even with the provision of such a sealing layer, however, several problems still arise; as driving time goes by, the light emission luminance decreases or the dark spots occur due to the influence of moisture coming from the outside. If the dark spots becomes large or the light emitting area becomes small, then the device will deteriorate and, in the worst case, the device will be disabled.

It is also proposed to incorporate a desiccating agent or desiccant in an airtight case with an organic EL structure received therein. For instance. JP-A 3-261091 discloses diphosphorus pentaoxide (P₂O₅) as the desiccant. However, P₂O₅ absorbs moisture, and yields phosphoric acid upon dissolution (deliquescence) in the resulting water, exerting an adverse influence on the organic EL structure. In addition, the use of P₂O₅ is impractical because some considerable limitation is imposed on how to incorporate it in the case.

JP-A 6-176867 discloses an organic EL device wherein a finely divided solid desiccant is filled in an outer protective case. For the finely divided solid desiccant, zeolite, activated alumina, silica gel and calcium oxide are referred to therein. However, the fabrication process of this organic EL structure becomes complicated because of the need of providing steps of filling the finely divided solid desiccant in the outer case, and mounting the outer case with the finely divided solid desiccant filled therein. In addition, when the desiccant like zeolite, to which moisture is physically adsorbed, is incorporated in the case while it comes into direct contact with the organic EL device, no sufficient service life is obtained because the moisture, once adsorbed to the desiccant, is released due to the heat generated upon the emission of light from the device.

On the other hand, JP-A 9-148066 discloses for the desiccant a compound capable of adsorbing moisture chemically and, nonetheless, maintaining a solid state even upon the adsorption of the moisture, for instance, an alkaline metal oxide, an alkaline earth metal oxide, a sulfate and a metal halide. These compounds allow a device to have a bit more increased service life because they adsorb moisture so chemically that any rerelease of moisture is unlikely. However, it is not easy to hold the solid desiccant in the airtight case and another step is needed therefor. In addition, the service life of the device is still less than satisfactory.

JP-A's 5-114486 and 5-41281 disclose how to store a device in an inert liquid compound containing a dehydrator and comprising a fluoridized hydrocarbon. Although this method has some effect on protecting an organic EL device against moisture, a device sealing process becomes more complicated because of the need of providing an additional step of pouring the dehydrator-containing inert liquid compound.

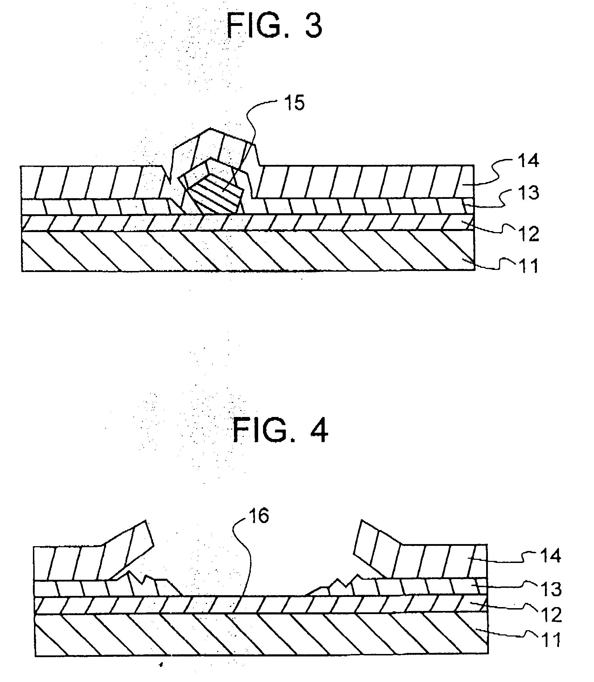

Another factor of the difficulty of fabricating the organic EL device is the fact that, in most cases, the organic layer interleaved between the positive and negative electrodes has a thickness of the order of 1 µm or less. In other words, when a dust 15 whose size is equal to or larger than that of an organic layer 13 formed on a substrate 11 is deposited on an electrode 12 located below the organic layer 13 before it is formed as shown in Fig. 3, a defect problem is likely to occur due to a short circuit between the electrode 12 and an electrode 14 to be formed on the organic layer.

At a defective pixel, for instance, a leakage current or a short circuit occurs between electrodes. When a display operates in a state where leakage currents occur, apparently clear defects show up. Especially when the display operates in a simple matrix driving mode, such defects become gravest. For instance, when a TV or computer display is prepared, it is likely that non-selected lines emit light or portions which must be essentially brightly displayed become dark. It is difficult to find out such defective portions until the quality of what is actually displayed by light emission is estimated.

Likewise, moisture is likely to penetrate through a portion with dust deposited thereon. As known in the art, this may often give rise to non-emitting spots (dark spots), which grow as time goes by.

To make correction for defects in the fabrication process of liquid crystal displays, a method called a laser repair method is generally used. According to this laser repair method, interconnections or particles where pixels have some defects are burned off by YAG laser or the like, as typically shown in Fig. 4, to remove dust-containing defective portions of the organic layer 13 and electrode 14 and thereby expose a portion of the electrode 12, as shown at 16. This method is now widely used as an effective means for yield improvements.

For the laser repair method, however, it is required to irradiate a display surface, etc. of the organic EL structure directly with laser light. In other words, this method cannot well be applied to a display comprising a color filter or the like located on its display surface side, because the laser light is absorbed in or cut off by the display surface or the like.

With such a conventional sealing means as mentioned above, it is also extremely difficult to properly locate the desiccant in an arrangement where light is taken out of a sealing sheet side, such as a so-called reverse multilayer arrangement comprising, in order from a substrate, an electron injecting electrode, an electron injecting and transporting layer, a light emitting layer, a hole injecting and transporting layer and a hole injecting electrode and so different from a conventional organic EL device arrangement.

As explained above, the prior art organic EL device has some difficulties in taking light out of the sealing sheet side, carrying out the laser repair method in an effective manner and making it compatible with existing sealing techniques. For this reason, the effect on preventing device defects such as a luminance decrease with the lapse of driving time and the occurrence and growth of dark spots is still insufficient. In addition, although the sealing process has some sealing effect, several problems arise due to its complexities, resulting in low yields and cost rises.

It is therefore an object of the invention to achieve an organic EL device which enables light to be taken out of a sealing sheet side, defective portions to be effectively repaired by a laser repair method and device products to be fabricated in high yields, and can prevent device defects such as a luminance decrease with the lapse of driving time and the occurrence and enlargement of dark spots.

### SUMMARY OF THE INVENTION

The above object is achieved by embodiments of the invention defined below.
(1) An organic electroluminescent device comprising a substrate, an organic electroluminescent structure formed on the substrate and a sealing sheet for sealing up the organic electroluminescent structure, wherein;
   said sealing sheet has a light transmittance of 80% or greater with respect to at least one of 355-nm wavelength light, 532-nm wavelength light and 1,064-nm wavelength light, and
   a desiccant is located on the inside of a junction for fixing said sealing sheet onto said substrate and on the outside of a space in which said organic electroluminescent structure is formed.
(2) The organic electroluminescent device according to (1) above, wherein said substrate has a light transmittance of 70% or lower with respect to at least one of 355-nm, 532-nm and 1,064-nm wavelength light components of light arriving from the outside of a sealing sheet side at said organic electroluminescent structure.
(3) The organic electroluminescent device according to (1) or (2) above, wherein said organic electroluminescent structure has a multilayer arrangement that allows emitted light to be taken out of a sealing sheet side.
(4) The organic electroluminescent device according to any one of (1) to (3) above, wherein said organic electroluminescent structure has a multilayer arrangement that permits emitted light to be taken out of both a substrate side and a sealing sheet side.
(5) An organic electroluminescent device comprising a substrate, an organic electroluminescent structure formed on the substrate and a sealing sheet for sealing up the organic electroluminescent structure, wherein:
   said sealing sheet has a light transmittance of 80% or greater with respect to at least one of 355-nm wavelength light, 532-nm wavelength light and 1,064-nm wavelength light,
   a desiccant is located on the inside of a junction for fixing said sealing sheet onto said substrate and on the outside of a space in which said organic electroluminescent structure is formed, and
   at least a part of said organic electroluminescent structure is repaired by laser.
(6) The organic electro luminescent device according to (5) above, wherein said substrate has a light transmittance of 70% or lower with respect to at least one of
   355-nm wavelength light, 532-nm wavelength light and 1,064-nm wavelength light.

### BRIEF DESCRIPTION OF THE DRAWINGS

Fig. 1 is a sectional view in schematic depicting an essential construction of the organic EL display device according to the invention.
Fig. 2 is a plan view of Fig. 1.
Fig. 3 is a sectional view in schematic depicting the state of dust deposited on layers in an organic EL structure during its formation.
Fig. 4 is a sectional view in schematic depicting a portion of an organic EL structure that is repaired by laser.

### DETAILED DESCRIPTION OF THE INVENTION

One embodiment of the organic EL display device of the invention comprises a substrate, an organic electroluminescent structure formed on the substrate and a sealing sheet for sealing up the organic electroluminescent structure, wherein the sealing sheet has a light transmittance of 80% or greater with respect to at least one of 355-nm wavelength light, 532-nm wavelength light and 1,064-nm wavelength light, and a desiccant is located inside of a junction for fixing the sealing sheet onto the substrate and outside of a space with the organic electroluminescent structure received therein.

According to the invention, the sealing sheet has a light transmittance with respect to at least one of 355-nm wavelength light, 532-nm wavelength light and 1,064-nm wavelength light, and the desiccant is located inside of a junction for fixing the sealing sheet onto the substrate and outside of a space with the organic electroluminescent structure received therein, so that the organic EL device can be strongly protected by the desiccant against moisture while it can be repaired by laser from the sealing sheet side, thereby achieving product yield improvements.

When the substrate has a light transmittance of 70% or lower, and especially about 0 to 50% with respect to any one of 355-nm, 532-nm and 1,064-nm light components of light arriving from the outside of the substrate at the organic EL structure through the substrate, it is preferable that the sealing sheet has a light transmittance of 80% or greater, and especially about 85 to 95% with respect to at least one of 355-nm wavelength light, 532-nm wavelength light and 1,064-nm wavelength light.

In the case of a reverse multilayer arrangement or an arrangement designed to take light out of the sealing sheet side, too, for instance, a device arrangement designed to take light out of both sides thereof, it is preferable that the sealing sheet has a light transmittance of 80% or greater, and especially about 85 to 95% with respect to at least a visible light region, and especially light of 350 to 700-nm wavelength in general, and 450 to 680-nm wavelength in particular.

Preferably but not exclusively, the sealing sheet should be made of a material capable of keeping an airtight state and having a given strength with the aforesaid laser light transmittance. The sealing sheet, preferably in a flat sheet, should thus be made of glasses, quartz, and resins, among which the glasses are preferred. By using a glass flat sheet, it is possible to achieve an inexpensive yet thin organic EL display device. In consideration of cost, alkali glasses are preferred. However, it is acceptable to use soda lime glass, lead alkali glass, borosilicate glass, aluminosilicate glass, and silica glass. In particular, a soda glass material subjected to no surface treatment is inexpensive and so is preferable. A plastic sheet, etc., too, may be used in place of the glass sealing sheet.

Preferably but not exclusively, the sealing sheet should be regulated to a proper size depending on display design, circuit design, etc. Usually, the sealing sheet in a flat form should have a thickness of the order of 0.1 to 5 mm. In the practice of the invention, it is acceptable to receive the whole or a part of the organic EL structure in a recess formed in the sealing sheet.

For height control, a spacer is used to keep the sealing sheet at a height as desired. The spacer material may be resin beads, silica beads, glass beads, glass fibers, etc., with the glass beads being most preferred. The spacer is usually in a particulate form having a uniform particle size. In the invention, however, a spacer of any desired shape may be used provided that it can function well. The spacer size should be preferably 1 to 20 µm, more preferably 1 to 10 µm, and even more preferably 2 to 8 µm as calculated on a circle diameter basis. A spacer having such a diameter should preferably have a particle length of up to about 100 µm. Although there is no particular lower limit to the particle size, the particle size should usually be equal to the diameter.

The spacer may or may not be used when a recess is provided in the sealing sheet. When the spacer is used, its size is preferably within the aforesaid range, and more preferably within the range of 2 to 8 µm.

The spacer may have been incorporated in the sealing adhesive agent or may be incorporated in the sealing adhesive at the time of bonding. The content of the spacer in the sealing adhesive agent should be preferably 0.01 to 30 wt%, and more preferably 0.1 to 5 wt%.

In consideration of an influence on the organic EL structure, it is preferable to use a photo-curing type adhesive agent for the sealing adhesive agent, although a thermosetting type adhesive agent may be used for the same purpose. For instance, use may be made of radical curing type adhesive agents using various acrylate resins such as ester acrylate, urethane acrylate, epoxy acrylate, melamine acrylate, and acrylic resin acrylate, and urethane polyester resin; cationic curing type adhesive agents using resins such as epoxy, and vinyl ether; and thiol·en addition type resin adhesive agents. Among these, preference is given to the cation curing type adhesive agent because there is no oxygenous obstacle and a polymerization reaction proceeds even after light irradiation.

A preferred example of the cation curing type adhesive agent is a cation curing epoxy resin adhesive agent of the ultraviolet curing type. Each of the organic layers forming the organic EL structure has a glass transition temperature of usually 140 C or lower, and especially about 80 to 100 C. For this reason, an ordinary thermosetting type adhesive agent cannot be used with an organic EL device, because its setting temperature is of the order of 140 to 180 C; the organic EL structure is softened upon the setting of the adhesive agent, resulting in a deterioration in its performance. With an ultraviolet curing type adhesive agent, on the other hand, such a softening problem does not arise. However, a commonly used current ultraviolet curing type adhesive agent is an acrylic adhesive agent which is found to have an adverse influence on structural materials forming the organic EL structure because of the volatilization of the acrylic monomer contained therein during curing. As a consequence, the performance of the organic EL structure suffers deterioration. In the practice of the invention, it is thus preferable to use the aforesaid cation curing type ultraviolet curing epoxy resin adhesive agent which is completely or substantially free of such problems.

Commercially available ultraviolet curing type epoxy resin adhesive agents include a combined ultraviolet and heat curing type epoxy resin adhesive agent. In this case, a radical curing type acrylic resin is often mixed or modified with a heat curing type epoxy resin. In other words, this adhesive agent is not preferable for use with the organic EL display of the invention because the problem incidental to the volatilization of the acrylic monomer in the acrylic resin or the problem in connection with the setting temperature of the thermosetting type resin remains still unsolved.

By the "cation curing type ultraviolet curing epoxy resin adhesive agent" used herein is intended an adhesive agent of the type which contains as a primary curing agent a Lewis acid-base type curing agent subjected to photo-decomposition upon ultraviolet or other light irradiation to release a Lewis acid catalyst, and in which a main component epoxy resin is polymerized and cured through a cation polymerization type reaction mechanism while a Lewis acid generated by light irradiation acts as a catalyst.

The epoxy resin contained as the main component in the aforesaid adhesive agent, for instance, includes an epoxidized olefin resin, an alicyclic epoxy resin, and a novolak epoxy resin. The aforesaid curing agent, for instance, includes a Lewis acid-base of aromatic diazonium, a Lewis acid-base of diallyliodonium, a Lewis acid-base of triallylsulfonium, and a Lewis acid-base of triallylselenium, among which the Lewis acid-base of diallyliodonium is preferred.

The amount of the adhesive agent to be coated is preferably 6 x 10⁻² to 2 x 10⁻⁴ g/cm², and especially 8 x 10⁻³ to 2 x 10⁻⁴ g/cm², although varying with the size of the organic EL structure stacked on the substrate or the type, structure and the like of a display built up of organic EL devices. The thickness of the adhesive agent layer should usually ensure that the predetermined space is available at the height at which the sealing sheet is located, i.e., in the thickness of the organic EL structure stacked on the substrate; it is of the order of usually 5 x 10⁵ to 1 x 10³ nm, preferably 5 x 10⁴ to 5 x 10³ nm and especially 2 x 10⁴ to 2 x 10³ nm, although the invention is not particularly limited thereto.

The sealing sheet is bonded and sealed up using the adhesive agent. An inert gas such as Ar, He, and N₂ is preferably used as a sealing gas. Then, the sealing gas should preferably have a moisture content of up to 100 ppm, especially up to 10 ppm, and more especially up to 1 ppm. Although there is no critical lower limit to the moisture content, the sealing gas should usually have a moisture content of about 0.1 ppm.

Although there is no critical limit to the practice of the invention, the desiccant used herein should have any desired hygroscopicity and be less susceptible to reactions with fixing organic compounds, etc. For instance, it is preferable to use calcium hydride (CaH₂), strontium hydride (SrH₂), barium hydride (BaH₂), aluminum lithium hydride (AlLiH₄), sodium oxide (Na₂O), potassium oxide (K₂O), calcium oxide (CaO), barium oxide (BaO), and magnesium oxide (MgO).

Among the above desiccants, calcium hydride (CaH₂), strontium hydride (SrH₂), barium hydride (BaH₂) and aluminum lithium hydride (AlLiH₄) are particularly preferred.

The desiccant should be located on the inside of the junction for fixing the sealing sheet onto the substrate and on the outside of the space with the organic EL structure formed therein. By locating the desiccant on the outside of the space with the films for the organic EL structure formed therein, it is possible to carry out laser repair from the sealing sheet side. This location of the desiccant is also effective for an arrangement allowing light to be taken out of the sealing sheet side. Although the desiccant may be located at any desired site provided that the aforesaid requirement is satisfied, it is preferable that the desiccant is located at a position where it comes into no contact with the organic EL structure. More preferably, the desiccant should be located such that all the periphery of the organic EL structure is covered with the desiccant and there is no gap between the desiccant and the sealing sheet and between the desiccant and the substrate, i.e., extraneous moisture always reaches the organic EL structure through the desiccant layer.

The desiccant may be located at a given position and in a given form by using a binder or incorporating it in an air-permeable resin.

For the binder, waxes, fats and oils, high-molecular resins, etc. may be used.

For the waxes, use may be made of waxes (for instance, petroleum type waxes such as paraffin wax and microcrystalline wax and natural waxes such as vegetable wax, animal wax and mineral wax) as well as organic compounds equivalent in nature to waxes, for instance, fats and oils (e.g., those called fats and solid fats). The components of waxes, and fats and oils are a hydrocarbon (e.g., an alkane type straight-chain hydrocarbon having at least 22 carbon atoms), a fatty acid (e.g., a fatty acid of an alkane type straight-chain hydrocarbon having at least 12 carbon atoms), a fatty acid ester (e.g., a methyl ester of a fatty acid obtained from a saturated fatty acid having at least 20 carbon atoms and a lower alcohol such as methyl alcohol), a fatty acid amide (e.g., an unsaturated fatty acid amide such as oleic acid amide and erucic acid amide), an aliphatic amine (e.g., an aliphatic primary amine having at least 16 carbon atoms), a higher alcohol (e.g., an n-alkyl alcohol having at least 16 carbon atoms), etc. Among these waxes, the petroleum waxes are particularly preferred.

For the high-molecular compound, use should preferably be made of a material that is capable of easy coating and less susceptible to reaction with the desiccant used in combination therewith. Preferably, the best selection should be made from the following materials used in combination with the desiccant. For instance, it is preferable to use resins such as polyethylene resin (PE) and polypropylene resin (PP). In this regard, it is acceptable to use an ethylene-vinyl acetate copolymer (EVA) having a vinyl acetate content of about 15 to 50% as a hot-melt material.

For use, the above high-molecular organic compound may be dissolved in a solvent, preferably a hydrocarbon or halogenated hydrocarbon solvent. The hydrocarbon or halogenated (F, Cl, Br and I) hydrocarbon solvent used for dissolving the high-molecular organic compound therein should solubilize the high-molecular organic compound and be less susceptible to chemical reaction with the desiccant mixed therewith. The solvent, too, should preferably be of low hygroscopicity.

For instance, it is preferable to make a reasonable selection from hexane, heptane, octane, cyclohexane, ethylcyclohexane, benzene, toluene, xylene, ethylbenzene, dichloromethane, chloroform, carbon tetrachloride, dichloroethane, trichloroethane, tetrachloroethane, dichloropropane, chlorobenzene, etc.

For use, the high-molecular organic compound is added to and dissolved in the solvent in an amount of about 10 to 150 parts by weight, and especially about 20 to 100 parts by weight per 100 parts by weight of solvent.

The content of the desiccant is 5 to 80% by weight, and especially 20 to 70% by weight relative to all components including the above organic compound. At a desiccant content of less than 5% by weight, the water absorption effect of the desiccant becomes insufficient. At a desiccant content of greater than 80% by weight, it is difficult to fix and hold the desiccant with the organic compound, resulting in a possible damage to the device due to the peeling-off of the desiccant. The desiccant is usually used while dispersed in the above organic compound. The desiccant has an average particle diameter of about 0.1 to 10 µm.

The amount of the mixture of the above high-molecular compound with the desiccant to be coated and located should preferably be from about 0.001 to 0.5 g/cm², and especially from about 0.01 to 0.1 g/cm², although varying with the specific gravity of the materials used. For coating, use may be made of blade coating, roll coating, brush coating and printing as well as a dispenser, etc. In this regard, it is acceptable to apply the mixture in a semi-solid state.

A transparent or semi-transparent material such as glass, quartz and resin may be used as a substrate material for an arrangement designed to take the emitted light out of the substrate side, and a transparent or opaque substrate may be used for a reverse lamination arrangement. For the opaque substrate, use may be made of a metal, ceramics, etc.

When, in the case of an arrangement designed to take light out of a substrate side, the substrate or a layer formed on either side thereof has a light transmittance of 70% or lower with respect to at least one of 355-nm, 532-nm and 1,064-nm wavelength light components of light arriving from the outside of the substrate at the organic EL structure, the sealing sheet should preferably have a light transmittance of 80% or greater, and especially about 85 to 90% with respect to at least one of 355-nm wavelength light, 532-nm wavelength light and 1,064-nm wavelength light.

In some cases, the colors of emitted light are controlled using a color filter film, a fluorescent substance-containing color conversion film or a dielectric reflecting film in combination with the substrate. When, in such cases, the substrate has a light transmittance of 70% or less with respect to at least one of 355-nm wavelength light, 532-nm wavelength light and 1,064-nm wavelength light components of light arriving from the outside of the substrate at the organic EL structure, it is difficult to perform laser repair from the substrate side. If the light transmittance of the sealing sheet with respect to at least one of 355-nm wavelength light, 532-nm wavelength light and 1,064-nm wavelength light is at least 80%, then the laser repair can be carried out from the sealing sheet side.

For the color filter film, a color filter employed with liquid crystal display devices may be used. However, it is preferable to control the properties of the color filter in conformity to the light emitted from the organic EL device, thereby optimizing the efficiency of taking out light emission and color purity.

By using a color filter capable of cutting off extraneous light of such short wavelength as absorbed by the EL device material or the fluorescent conversion layer, it is possible to improve the light resistance of the device and the contrast of what is displayed on the device.

Instead of the color filter, an optical thin film such as a dielectric multilayer film may be used.

The fluorescent color conversion film absorbs light emitted from an EL device and gives out light from the fluorescent substance contained therein for the color conversion of light emission, and is composed of three components, a binder, a fluorescent material and a light absorbing material.

In the practice of the invention, it is basically preferable to use a fluorescent material having high fluorescent quantum efficiency, and especially a fluorescent material having strong absorption in an EL light emission wavelength region. Laser dyes are suitable for the practice of the invention. To this end, for instance, it is preferable to use rohodamine compounds, perylene compounds, cyanine compounds, phthalocyanine compounds (including subphthalocyanine compounds, etc.), naphthaloimide compounds, fused cyclic hydrocarbon compounds, fused heterocyclic compounds, styryl compounds, and coumarin compounds.

For the binder, it is basically preferable to make an appropriate selection from materials that do not extinguish fluorescence. It is particularly preferable to use a material that can be finely patterned by photolithography, printing or the like. It is also preferable to use a material that is not damaged during ITO or IZO film formation.

The light absorbing material is used when light is not fully absorbed by the fluorescent material, and so may be dispensed with, if not required. For the light absorbing material, it is preferable to make a selection from materials that do not extinguish fluorescence.

The organic EL device of the invention will now be explained more illustratively with reference to the accompanying drawings.

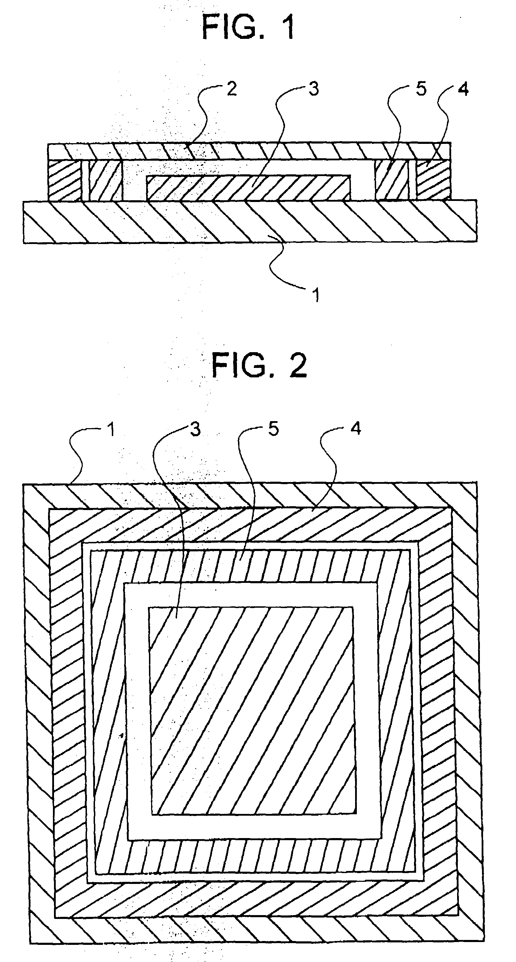

Fig. 1 is a sectional view in schematic illustrating one embodiment of the organic EL device according to the invention. As shown in Fig. 1, this embodiment comprises an organic EL structure 3 formed on a substrate 1 and a sealing sheet 2 located with a given spacing between it and the organic EL structure 3 such that the organic EL structure 3 is covered therewith. The sealing sheet is bonded and fixed in place by use of an adhesive agent 4. Then, a desiccant 5 is located on the inside of a junction for fixing the sealing sheet onto the substrate by means of the adhesive agent 4 and on the outside of a space with the organic EL structure 3 formed therein.

The light emitted from the organic EL structure may be taken out the substrate side and/or the sealing sheet side depending on the multilayer construction, electrode construction, etc. of the organic EL structure. Preferably in this case, the light transmittance of the substrate or sealing sheet out of which the light is taken should have a transmittance of at least 80%, and especially at least 85% at visible wavelengths of especially 350 to 700 nm, and more especially 450 to 680 nm.

The organic EL structure of the invention may be constructed as follows.

For the hole injecting electrode, it is usually preferable to use a transparent or translucent electrode because this electrode is usually formed as an electrode on the substrate side and constructed such that the emitted light is taken out therefrom. The material for such a transparent electrode, for instance, includes ITO (tin-doped indium oxide), IZO (zinc-doped indium oxide), ZnO, SnO₂ and In₂O₃, with ITO (tin-doped indium oxide) and IZO (zinc-doped indium oxide) being preferred. Usually, ITO contains In₂O₃ and SnO in a stoichiometric composition. However, the amount of O may deviate slightly from the stoichiometric composition.

The hole injecting electrode should preferably have at least a certain thickness enough for hole injection or a thickness in the range of usually 10 to 500 nm, and especially 30 to 300 nm. Although there is no upper limit to the thickness, it is understood that too thick a hole injecting electrode poses problems, e.g., defoliation, poor processability, damage by stress, light transmittance drops, and leakage due to surface roughness. Too thin a hole injecting electrode, on the contrary, offers problems in terms of film strength upon fabrication, hole transportation capability, and resistance value.

The hole injecting electrode layer may be formed by an evaporation process, however, it should preferably be formed by a sputtering process.

The electrode, out of which light is taken, should have a light transmittance of 50% or greater, preferably 60% or greater, especially 80% or greater, and more especially 90% or greater with respect to emitted light at a light emission frequency band of usually 400 to 700 nm. If the transmittance of the electrode becomes low, there is then a fear that the luminance necessary for a light emitting device is not obtained due to an attenuation of the light itself emitted from the light emitting layer. For the purposes of increasing contrast ratio, visuality, etc., it is acceptable to reduce the transmittance down to a relatively low level.

For the electron injecting electrode, it is preferable to use a substance having a low work function, for instance, pure metal elements such as K, Li, Na, Mg, La, Ce, Ca, Sr, Ba, Al, Ag, In, Sn, Zn and Zr, and a binary or ternary alloy system thereof that serves as a stabilizer for the electron injecting electrode. Preferable alloy systems to this end, for instance, are Ag·Mg (Ag: 1 to 20 at%), Al·Li (Li: 0.3 to 14 at%). In·Mg (Mg: 50 to 80 at%), and Al·Ca (Ca: 5 to 20 at%). It is also preferable to form these oxides in combination with an auxiliary electrode. It is noted that the electron injecting electrode may be formed by either an evaporation process or a sputtering process.

The electron injecting electrode thin film should preferably have at least a certain thickness enough for electron injection or a thickness in the range of 0.1 nm or greater, and more especially 1 nm or greater. Although there is no upper limit to the thickness, it is preferable that the thin film has usually a thickness of about 1 to 500 nm.

In the normal multilayer arrangement, a protective electrode may be provided on the electron injecting electrode. The protective electrode may have at least a certain thickness enough to make sure of electron injection efficiency and prevent penetration of moisture, oxygen or organic solvents or a thickness in the range of at least 50 nm, preferably at least 100 nm, and especially 100 to 1,000 nm. With too thin a protective electrode layer, neither are the advantages of the invention obtainable, nor is sufficient connection with terminal electrodes obtainable because the ability of the protective electrode layer to cover steps becomes low. When the protective electrode layer is too thick, on the other hand, the growth rate of dark spots becomes high because of an increase in the stress of the protective electrode layer.

Preferably but not exclusively, the total thickness of the electron injecting, electrode plus the protective electrode is usually of the order of 100 to 1,000 nm.

In addition to the aforesaid protective electrode, an additional protective film may be formed after the formation of the electrode. The protective film may be formed of either an inorganic material such as SiOₓ or an organic material such as Teflon, and a chlorine-containing carbon fluoride polymer. The protective film may be either transparent or opaque, and has a thickness of the order of 50 to 1,200 nm. The protective film may be formed either by the aforesaid reactive sputtering process or conventional processes such as general sputtering, evaporation or PECVD.

Next, the organic material layers of the organic EL structure are explained.

The light emitting layer comprises an organic compound thin film at least taking part in a light emitting function or a multilayer film made up of two such organic compound thin films.

The light emitting layer has functions of injecting holes and electrons, transporting them, and recombining holes and electrons to create excitons. For the light emitting layer, it is preferable to use a relatively electronically neutral compound so as to inject and transport electrons and holes in an easy, well-balanced state.

In addition to the light emitting layer in a narrow sense and if required, the above light emitting layer may be provided with a hole transporting layer, an electron injecting and transporting layer, etc., each formed of an organic material.

The hole transporting layer, provided if required, has functions of facilitating injection of holes from the hole injecting electrode, providing stable transportation of holes and blocking electrons, and the electron injecting and transporting layer, provided if required, has functions of facilitating injection of electrons from the electron injecting electrode, providing stable transportation of electrons and blocking holes. These layers are effective for increasing the number of holes and electrons injected into the light emitting layer and confining holes and electrons therein for optimizing the recombination region to improve emission efficiency.

The thickness of the light emitting layer, the hole transporting layer, and the electron injecting and transporting layer is not critical and varies with a particular formation technique although it is usually of the order of preferably 5 to 500 nm, and especially 10 to 300 nm.

The thickness of the hole transporting layers, and the electron injecting and transporting layer is equal to, or about 1/10 times to about 10 times as large as, the thickness of the light emitting layer although it depends on the design of the recombination/light emitting region. When the electron injecting and transporting layer is separated into an injecting layer and a transporting layer, it is preferable that the injecting layer is at least 1 nm thick and the transporting layer is at least 1 nm thick. The upper limit to thickness is usually about 500 nm for the injecting layer and about 500 nm for the transporting layer. The same film thickness applies when two injecting and transporting layers are provided.

In the organic EL display according to the invention, the light emitting layer contains a fluorescent material that is a compound capable of emitting light. The fluorescent material used herein, for instance, may be at least one compound selected from compounds such as those disclosed in JP-A 63-264692, e.g., quinacridone, rubrene, and styryl dyes. Use may also be made of quinoline derivatives such as metal complex dyes containing 8-quinolinol or its derivative as ligands, for instance, tris(8-quinolinolato)aluminum, tetraphenylbutadiene, anthracene, perylene, coronene, and 12-phthaloperinone derivatives. Use may further be made of phenylanthracene derivatives disclosed in JP-A 8-12600 (Japanese Patent Application No. 6-110569), and tetraarylethene derivatives disclosed in JP-A 8-12969 (Japanese Patent Application No. 6-114456).

Preferably, the fluorescent compound is used in combination with a host substance capable of emitting light by itself; that is, it is preferable that the fluorescent compound is used as a dopant. In such a case, the content of the fluorescent compound in the light emitting layer is in the range of preferably 0.01 to 10% by weight, and especially 0.1 to 5% by weight. By using the fluorescent compound in combination with the host substance, it is possible to vary the wavelength performance of light emission, thereby making light emission possible on a longer wavelength side and, hence, improving the light emission efficiency and stability of the device.

Quinolinolato complexes, and aluminum complexes containing 8-quinolinol or its derivatives as ligands are preferred for the host substance. Such aluminum complexes are typically disclosed in JP-A's 63-264692, 3-255190, 5-70773, 5-258859, 6-215874, etc.

Exemplary aluminum complexes include tris(8-quinolinolato)aluminum, bis(8-quinolinolato)magnesium, bis(benzo{f}-8-quinolinolato)zinc, bis(2-methyl-8-quinolinolato)aluminum oxide, tris(8-quinolinolato)indium, tris(5-methyl-8-quinolinolato)aluminum, 8-quinolinolato-lithium, tris( 5-chloro-8-quinolinolato)gallium, bis(5-chloro-8-quinolinolato)calcium, 5,7-dichloro-8-quinolinolato-aluminum, tris(5,7-dibromo-8-hydroxyquinolinolato)aluminum, and poly[zinc(II)-bis(8-hydroxy-5-quinolinyl)methane].

Use may also be made of aluminum complexes containing other ligands in addition to 8-quinolinol or its derivatives, for instance, bis(2-methyl-8-quinolinolato)(phenolato) aluminum (III), bis(2-methyl-8-quinolinolato)(o-cresolato) aluminum (III), bis(2-methyl-8-quinolinolato)(m-cresolato) aluminum (III), bis(2-methyl-8-quinolinolato)(p-cresolato) aluminum (III), bis(2-methyl-8-quinolinolato)(o-phenyl-phenolato)aluminum (III), bis(2-methyl-8-quinolinolato)(m-phenylphenolato)aluminum (III), bis(2-methyl-8-quinolinolato) (p-phenylphenolato)aluminum (III), bis(2-methyl-8-quinolinolato)(2,3-dimethylphenolato)aluminum (III), bis(2-methyl-8-quinolinolato)(2,6-dimethylphenolato)aluminum (III), bis(2-methyl-8-quinolinolato)(3,4-dimethylphenolato)aluminum (III), bis(2-methyl-8-quinolinolato)(3,5-dimethylphenolato) aluminum (III), bis(2-methyl-8-quinolinolato)(3,5-di-tert-butylphenolato)aluminum (III), bis(2-methyl-8-quinolinolato)(2,6-diphenylphenolato)aluminum (III), bis(2-methyl-8-quinolinolato)(2,4,6-triphenylphenolato)aluminum (III), bis(2-methyl-8-quinolinolato)(2,3,6-trimethylphenolato)aluminum (III), bis(2-methyl-8-quinolinolato) (2,3,5,6-tetramethylphenolato)aluminum (III), bis(2-methyl-8-quinolinolato)(1-naphtholato)aluminum (III), bis(2-methyl-8-quinolinolato)(2-naphtholato)aluminum (III), bis(2,4-dimethyl-8-quinolinolato)(o-phenylphenolato)aluminum (III), bis( 2,4-dimethyl-8-quinolinolato)(p-phenylphenolato)aluminum (III), bis(2,4-dimethyl-8-quinolinolato)(m-phenylphenolato) aluminum (III), bis(2,4-dimethyl-8-quinolinolato)(3,5-dimethylphenolato)aluminum (III), bis(2,4-dimethyl-8-quinolinolato)(3,5-di-tert-butylphenolato)aluminum (III), bis(2-methyl-4-ethyl-8-quinolinolato)(p-cresolato)aluminum (III), bis(2-methyl-4-methoxy-8-quinolinolato)(p-phenylphenolato)aluminum (III), bis(2-methyl-5-cyano-8-quinolinolato)(o-cresolato)aluminum (III), and bis(2-methyl-6-trifluoromethyl-8-quinolinolato)(2-naphtholato)aluminum (III).

Besides, use may be made of bis(2-methyl-8-quinolinolato)aluminum (III)-µ-oxo-bis(2-methyl-8-quinolinolato) aluminum (III), bis(2,4-dimethyl-8-quinolinolato)aluminum (III)-µ-oxo-bis(2,4-dimethyl-8-quinolinolato)aluminum (III), bis(4-ethyl-2-methyl-8-quinolinolato)aluminum (III)-µ-oxo-bis(4-ethyl-2-methyl-8-quinolinolato)aluminum (III), bis(2-methyl-4-methoxyquinolinolato)aluminum (III)-µ-oxo-bis(2-methyl-4-methoxyquinolinolato)aluminum (III), bis(5-cyano-2-methyl-8-quinolinolato)aluminum (III)-µ-oxo-bis(5-cyano-2-methyl-8-quinolinolato)aluminum (III), bis(2-methyl-5-trifluoromethyl-8-quinolinolato)aluminum (III)-µ-oxo-bis(2-methyl-5-trifluoromethyl-8-quinolinolato)aluminum (III), etc.

Other preferable host substances include phenylanthracene derivatives disclosed in JP-A 8-12600 (Japanese Patent Application No. 6-110569), tetraarylethene derivatives disclosed in JP-A 8-12969 (Japanese Patent Application No. 6-114456), etc.

In the practice of the invention, the light emitting layer may also serve as an electron injecting and transporting layer. In this case, it is preferable to use a fluorescent material, e.g., tris(8-quinolinolato)aluminum or the like, which may be provided by evaporation.

If necessary or preferably, the light emitting layer is formed of a mixed layer of at least one compound capable of injecting and transporting holes with at least one compound capable of injecting and transporting electrons. Preferably in this case, a dopant is incorporated in the mixed layer. The content of the dopant compound in the mixed layer is in the range of preferably 0.01 to 20% by weight, and especially 0.1 to 15% by weight.

In the mixed layer with a hopping conduction path available for carriers, each carrier migrates in the polarly prevailing substance, so making the injection of carriers having an opposite polarity unlikely to occur. This leads to an increase in the service life of the device due to less damage to the organic compound. By incorporating the aforesaid dopant in such a mixed layer, it is possible to vary the wavelength performance of light emission that the mixed layer itself possesses, thereby shifting the wavelength of light emission to a longer wavelength side and improving the intensity of light emission, and the stability of the device as well.

The compound capable of injecting and transporting holes and the compound capable of injecting and transporting electrons, both used to form the mixed layer, may be selected from compounds for the injection and transportation of holes and compounds for the injection and transportation of electrons, as will be described later. Especially for the compounds for the injection and transportation of holes, it is preferable to use amine derivatives having strong fluorescence, for instance, hole transporting materials such as triphenyldiamine derivatives, styrylamine derivatives, and amine derivatives having an aromatic fused ring.

For the compounds capable of injecting and transporting electrons, it is preferable to use metal complexes containing guinoline derivatives, especially 8-guinolinol or its derivatives as ligands, in particular, tris(8-quinolinolato) aluminum (Alq3). It is also preferable to use the aforesaid phenylanthracene derivatives, and tetraarylethene derivatives.

For the compounds for the injection and transportation of holes, it is preferable to use amine derivatives having strong fluorescence, for instance, hole transporting materials such as triphenyldiamine derivatives, styrylamine derivatives, and amine derivatives having an aromatic fused ring.

In this case, the ratio of mixing the compound capable of injecting and transporting holes with the compound capable of injecting and transporting electrons is determined while the carrier mobility and carrier density are taken into consideration. In general, however, it is preferred that the weight ratio between the compound capable of injecting and transporting holes and the compound capable of injecting and transporting electrons is of the order of 1/99 to 99/1, particularly 10/90 to 90/10, and more particularly 20/80 to 80/20.

The thickness of the mixed layer must correspond to the thickness of a single molecular layer, arid so is preferably less than the thickness of the organic compound layer. More specifically, the mixed layer has a thickness of preferably 1 to 85 nm, especially 5 to 60 nm, and more especially 5 to 50 nm.

Preferably, the mixed layer is formed by co-evaporation where the selected compounds are evaporated from different evaporation sources. When the compounds to be mixed have identical or slightly different vapor pressures (evaporation temperatures), however, they may have previously been mixed together in the same evaporation board for the subsequent evaporation. Preferably, the compounds are uniformly mixed together in the mixed layer. However, the compounds in an archipelagic form may be present in the mixed layer. The light emitting layer may generally be formed at a given thickness by the evaporation of the organic fluorescent substance or coating a dispersion of the organic fluorescent substance in a resin binder.

For the hole injecting and transporting layer, use may be made of various organic compounds as disclosed in JP-A's 63-295695, 2-191694, 3-792, 5-234681, 5-239455, 5-299174, 7-126225, 7-126226 and 8-100172 and EP 0650955A1. Examples are tetraarylbenzidine compounds (triaryldiamine or triphenyl-diamine (TPD)), aromatic tertiary amines, hydrazone derivatives, carbazole derivatives, triazole derivatives, imidazole derivatives, oxadiazole derivatives having an amino group, and polythiophenes. Where these compounds are used in combination of two or more, they may be stacked as separate layers, or otherwise mixed.

When the hole injecting and transporting layer is provided as a separate hole injecting layer and a separate hole transporting layer, two or more compounds are selected in a preferable combination from the compounds already mentioned for the hole injecting and transporting layer. In this regard, it is preferred to laminate layers in such an order that a compound layer having a lower ionization potential is disposed nearest to the hole injecting electrode (ITO, etc.). It is also preferred to use a compound having good thin film forming ability at the surface of the hole injecting electrode. This order of lamination holds for the provision of two or more hole injecting and transporting layers, and is effective as well for lowering driving voltage and preventing the occurrence of current leakage and the appearance and growth of dark spots. Since evaporation is utilized in the manufacture of devices, films as thin as about 1 to 10 nm can be formed in a uniform and pinhole-free state, which restrains any change in color tone of light emission and a drop of efficiency by re-absorption even if a compound having a low ionization potential and absorption in the visible range is used in the hole injecting layer. Like the light emitting layer and so on, the hole injecting and transporting layer or layers may be formed by evaporating the aforesaid compounds.

For the electron injecting and transporting layer which is provided if necessary, there may be used quinoline derivatives such as organic metal complexes containing 8-quinolinol or its derivatives as ligands, for instance, tris(8-quinolinolato)aluminum (Alq3), oxadiazole derivatives, perylene derivatives, pyridine derivatives, pyrimidine derivatives, quinoxaline derivative, diphenylquinone derivatives, and nitro-substituted fluorene derivatives. The electron injecting and transporting layer may also serve as a light emitting layer. In this case, it is preferable to use tris(8-quinolilato)aluminum, etc. As is the case with the light emitting layer, the electron injecting and transporting layer may then be formed by evaporation or the like.

Where the electron injecting and transporting layer is a double-layered structure comprising an electron injecting layer and an electron transporting layer, two or more compounds are selected in a preferably combination from the compounds commonly used for electron injecting and transporting layers. In this regard, it is preferred to laminate layers in such an order that a compound layer having a greater electron affinity is disposed nearest to the electron injecting electrode. This order of lamination also applies where a plurality of electron injecting and transporting layers are provided.

To form the hole injecting and transporting layer, the light emitting layer and the electron injecting and transporting layer, it is preferable to use a vacuum evaporation technique which enables a homogeneous thin film to be obtained. According to the vacuum evaporation process, it is possible to obtain homogeneous thin films in an amorphous state or with a crystal grain diameter of at most 0.2 µm. The use of a thin film having a crystal grain diameter exceeding 0.2 µm results in non-uniform light emission. To avoid this, it is required to increase the driving voltage of the device; however, there is a striking drop of hole injection efficiency.

No particular limitation is imposed on vacuum evaporation conditions. However, the rate of deposition by evaporation of the order of 0.01 to 1 nm/sec, is preferably applied at a degree of vacuum of 10⁻⁴ Pa or lower. It is also preferable to form the layers continuously in vacuum. If the layers are continuously formed in vacuum, high properties are then obtained because the adsorption of impurities on the interface between the adjacent layers can be avoided. Furthermore, the driving voltage of the device can be lowered while the growth and occurrence of dark spots are inhibited.

When the vacuum evaporation process is used to form the layers, each containing a plurality of compounds, it is preferable to carry out co-evaporation while boats charged with the compounds are individually placed under temperature control.

The organic EL device of the invention may be provided either as a normal multilayer arrangement comprising, in order from a substrate, a hole injecting electrode, a hole injecting and transporting layer, a light emitting layer, an electron injecting and transporting layer and an electron injecting electrode or as a reverse multilayer arrangement comprising, in order from a substrate, an electron injecting electrode, an electron injecting and transporting layer, a light emitting layer, a hole injecting and transporting layer and a hole injecting electrode.

If the electron injecting electrode is formed of a transparent material or an extremely thin film form of electron injecting electrode is used in combination with other transparent electrode, it is then possible to take light out of the electron injecting electrode, so that light can be taken out of both sides of the device.

The organic EL device of the invention is generally of the DC or pulse drive type while it may be of the AC drive type. The applied voltage is generally of the order of 2 to 30 V.

### EXAMPLE

### Example 1

### Preparation of Desiccant/Resin Mixture: Sample 1

A wax (made by Nikka Seiko Co., Ltd. under the trade name of Proof Wax and having a melting point of about 90 ) was used as the organic compound and CaH₂ was used as the desiccant. The wax was heated to 150 C in an N₂ atmosphere having a moisture content reduced to 100 ppm or less. Then, 100 parts by weight of the wax were added to and mixed with 100 parts by weight of the desiccant under agitation, thereby obtaining a desiccant/resin mixture.

Next, the desiccant/resin mixture was coated on the surface of the sealing sheet opposite to the organic EL structure over an area from the portion of the sealing sheet to the organic EL structure to the junction for fixing the sealing sheet onto the substrate while the portion of the sealing sheet opposite to the organic EL structure was spaced about 0.5 mm away form the junction. The then coating amount was about 0.05 g/cm².

The glass sealing sheet with the desiccant/resin mixture coated thereon was allowed to stand alone at room temperature for cooling. At room temperature the desiccant/resin mixture was cured while no mixture fluidization was found whatsoever.

### Preparation of Desiccant/Resin Mixture: Sample 2

A polyethylene resin (made by Mitsui Chemical Industries, Ltd. under the trade name of High-Wax 410P and having a melting point of 118 ) was used as the organic compound and CaH₂ was used as the desiccant. The resin was heated to 150 C in an N₂ atmosphere having a moisture content reduced to 100 ppm or less. Then, 100 parts by weight of the resin were added to and mixed with 100 parts by weight of the desiccant under agitation, thereby obtaining a desiccant/resin mixture.

Next, the desiccant/resin mixture was coated on the surface of the sealing sheet opposite to the organic EL structure over an area from the portion of the sealing sheet to the organic EL structure to the junction for fixing the sealing sheet onto the substrate while the portion of the sealing sheet opposite to the organic EL structure was spaced about 0.5 mm away form the junction. The then coating amount was about 0.05 g/cm².

The glass sealing sheet with the desiccant/resin mixture coated thereon was allowed to stand alone at room temperature for cooling. At room temperature the desiccant/resin mixture was cured while no mixture fluidization was found whatsoever.

### Preparation of Desiccant/Resin Mixture: Sample 3

Polystyrene (having a number-average molecular weight of 350,000) was used as the organic compound, toluene was used as the solvent and CaH₂ was used as the desiccant. In an N₂ atmosphere, 50 parts by weight of the resin were added to and mixed with 100 parts by weight of the desiccant under agitation, thereby obtaining a desiccant/resin mixture.

Next, the desiccant/resin mixture was coated on the surface of the sealing sheet opposite to the organic EL structure over an area from the portion of the sealing sheet to the organic EL structure to the junction for fixing the sealing sheet onto the substrate while the portion of the sealing sheet opposite to the organic EL structure was spaced about 0.5 mm away form the junction. The then coating amount was about 0.05 g/cm².

The glass sealing sheet with the desiccant/resin mixture coated thereon was allowed to stand alone at 150 C for removal of the catalyst and drying. At room temperature the desiccant/resin mixture was completely cured while no mixture fluidization was found whatsoever.

### Preparation of Organic EL Device

A glass substrate (Substrate 7059 made by Corning Co., Ltd.) was scrubbed with neutral detergent.

An auxiliary interconnecting line 11 was formed on the glass substrate, and then a pigment dispersion type RED color filter layer was formed thereon. This was a material with a pigment dispersed in an acrylic resin, which material had been obtained by repeating a process comprising spin coating, prebaking, exposure, development and curing of a commercially available chemical liquid.

To make the surface of the color filter layer flat, a colorless, transparent overcoat layer again based on an acrylic resin was formed in the same manner as the color filter layer. These layers were provided with contact holes connected to an ITO electrode (to be formed as mentioned just below) and the auxiliary interconnecting line. The color filter layer had a laser light transmittance of 10% or less at 532-nm wavelength.

Using an ITO oxide target at a substrate temperature of 250 C, an ITO hole injecting electrode layer of 200 nm in thickness was formed by an RF magnetron sputtering process on the substrate with the color filter layer formed thereon, and then patterned according to 2 mm x 2 mm dot pixels.

The substrate with the ITO electrode layer, etc. formed thereon was washed on the surface with UV/O₃, and then fixed to a substrate holder, which was in turn evacuated to 1 x 10⁻⁴ Pa or lower.

Next, 4,4',4''-tris(-N-(3-methylphenyl)-N-phenylamino) triphenylamine (m-MTDATA) was deposited by evaporation at a rate of deposition of 0.1 nm/sec. on the substrate to a thickness of 55 nm to form a hole injecting layer, and N,N'-diphenyl-N,N'-m-tolyl-4,4'-diamino-1,1'-biphenyl (TPD) was deposited by evaporation at a rate of deposition of 0.1 nm/sec, thereon to a thickness of 20 nm to form a hole transporting layer.

While the vacuum was still maintained, N,N,N',N'-tetrakis(m-biphenyl)-1,1'-biphenyl-4,4'-diamine (TPD), tris(8-quinolinolato)aluminum (Alq3) and rubrene were deposited by evaporation at an overall rate of deposition of 0.2 nm/sec. to a thickness of 100 nm to form a light emitting layer. A mixture of TPD:Alq3 = 1:1 by weight was doped with 10% by volume of rubrene.

Then, tris(8-quinolinolato)aluminum (Alq3) was deposited by evaporation at a rate of deposition of 0.2 nm/sec. to a thickness of 100 nm, thereby obtaining an electron injecting and transporting layer.

While the vacuum was still kept, AlLi (Li: 7 at%) was deposited by evaporation to a thickness of 1 nm and Al was subsequently deposited by evaporation to a thickness of 200 nm, thereby obtaining an electron injecting and electrode and an auxiliary electrode.

Each of sealing sheet samples 1 to 3, with the desiccant/organic compound mixture coated and located, was fixed to the obtained substrate with the organic EL structure stacked thereon. For the purpose of comparison, a sealing sheet having no desiccant/organic compound mixture was fixed to the substrate. This sealing sheet had a laser light transmittance of 90% at 532-nm wavelength. For the adhesive agent, an epoxy type photo-curing adhesive agent was used.

Each of ten organic EL device samples obtained in this way was continuously driven at a current density of 10 mA/cm² under 60 C/95% RH storage conditions. After the lapse of 500 hours, the light emitting surface was examined by observing whether or not dark spots were found for each pixel. It was consequently noted that when the inventive samples 1 to 3 were used, two dark spots of less than 50 µm in diameter or so were found. When the comparative sample was used, however, at least 15 dark spots of greater than 50 µm in diameter were found.

From a number of organic EL devices obtained using the inventive samples 1 to 3, pixels having leakage currents were searched out. Then, these pixels were irradiated with 532-nm wavelength YAG laser from the sealing sheet side for laser repair. Consequently, the pixels could be effectively laser repaired. It was thus found that pixels having leakage currents could be effectively repaired.

### Example 2

Each sample was obtained following Example 1 with the exception that an organic EL device was prepared as follows.

### Preparation of Organic EL Device

A glass substrate (Substrate 7059 made by Corning Co., Ltd.) was scrubbed with neutral detergent.

Next, Al was deposited by evaporation to a thickness of 200 nm, and AlLi (Li: 7 at%) was then deposited by evaporation to a thickness of 1 nm, thereby forming an auxiliary electrode and an electron injecting electrode.

Then, tris(8-quinolinolato)aluminum (Alq3) was deposited by evaporation at a rate of deposition of 0.2 nm/sec. to a thickness of 100 nm, thereby obtaining an electron injecting and transporting layer.

While the vacuum was still maintained, N,N,N',N'-tetrakis(m-biphenyl)-1,1'-biphenyl-4,4'-diamine (TPD), tris(8-quinolinolato)aluminum (Alq3) and rubrene were deposited by evaporation at an overall rate of deposition of 0.2 nm/sec. to a thickness of 100 nm to form a light emitting layer. A mixture of TPD:Alq3 = 1:1 by weight was doped with 10% by volume of rubrene.

Next, N,N'-diphenyl-N,N'-m-tolyl-4,4'-diamino-1,1'-biphenyl (TPD) was deposited by evaporation at a rate of deposition of 0.1 nm/sec. to a thickness of 20 nm to form a hole transporting layer, and 4,4',4''-tris(-N-(3-methylphenyl)-N-phenylamino)triphenylamine (m-MTDATA) was then deposited by evaporation at a rate of deposition of 0.1 nm/sec. on the substrate to a thickness of 55 nm to form a hole injecting layer.

Using an ITO oxide target, an ITO hole injecting electrode layer of 200 nm in thickness was formed by an RF magnetron sputtering process.

Each of sealing sheet samples 1 to 3, with the desiccant/organic compound mixture coated and located, was fixed to the obtained substrate with the organic EL structure stacked thereon. For the purpose of comparison, a sealing sheet having no desiccant/organic compound mixture was fixed to the substrate. This sealing sheet had a laser light transmittance of 90% at 532-nm wavelength. For the adhesive agent, an epoxy type photo-curing adhesive agent was used.

Each of the obtained samples was estimated as in Example 1. Consequently, much the same results as in Example 1 were obtained. When each sample was driven at a current density of 10 mA/cm², it was found that light was emitted from the sealing sheet side of the sample.

As in Example 1, effective reparing was feasible so that pixels having leakage currents could be effectively repaired.

### Example 3

Samples were obtained as in Example 1 with the exception that subsequently to the 1-nm thick deposition by evaporation of AlLi (Li; 7 at%), an ITO film of 200 nm in thickness was formed by RF magnetron sputtering to form an electron injecting electrode and an auxiliary electrode.

Each of the obtained samples was estimated as in Example 1. Consequently, much the same results as in Example 1 were obtained. When each sample was driven at a current density of 10 mA/cm², it was found that light was emitted from both (upper and lower) sides of the device sample.

As in Example 1, effective reparing was feasible so that pixels having leakage currents could be effectively repaired.

### ADVANTAGES OF THE INVENTION

According to the invention as explained above, it is thus possible to achieve an organic EL device which can be effectively laser-repaired so that defective portions can be properly repaired, enables device products to be fabricated in high yields, and can prevent device defects such as a luminance decrease with the lapse of driving time and the occurrence and enlargement of dark spots.

Although some preferred embodiments have been described, many modifications and variations may be made thereto in the light of the above teachings. It is therefore to be understood that within the scope of the appended claims, the invention may be practiced otherwise than as specifically described.

Japanese Patent Application No. 11-8456 is herein incorporated by reference.

## Claims

1. An organic electroluminescent device comprising a substrate, an organic electroluminescent structure formed on the substrate and a sealing sheet for sealing up the organic electroluminescent structure, wherein:
said sealing sheet has a light transmittance of 80% or greater with respect to at least one of 355-nm wavelength light, 532-nm wavelength light and 1,064-nm wavelength light, and
a desiccant is located on the inside of a junction for fixing said sealing sheet onto said substrate and on the outside of a space in which said organic electroluminescent structure is formed.

2. The organic electroluminescent device according to claim 1, wherein said substrate has a light transmittance of 70% or lower with respect to at least one of 355-nm, 532-nm and 1,064-nm wavelength light components of light arriving from the outside of a sealing sheet side at said organic electroluminescent structure.

3. The organic electroluminescent device according to claim 1 or 2, wherein said organic electroluminescent structure has a multilayer arrangement that allows emitted light to be taken out of a sealing sheet side.

4. The organic electroluminescent device according to any one of claims 1 to 3, wherein said organic electroluminescent structure has a multilayer arrangement that permits emitted light to be taken out of both a substrate side and a sealing sheet side.

5. An organic electroluminescent device comprising a substrate, an organic electroluminescent structure formed on the substrate and a sealing sheet for sealing up the organic electroluminescent structure, wherein:
said sealing sheet has a light transmittance of 80% or greater with respect to at least one of 355-nm wavelength light, 532-nm wavelength light and 1,064-nm wavelength light,
a desiccant is located on the inside of a junction for fixing said sealing sheet onto said substrate and on the outside of a space in which said organic electroluminescent structure is formed, and
at least a part of said organic electroluminescent structure has been repaired by laser.

6. The organic electro luminescent device according to claim 5, wherein said substrate has a light transmittance of 70% or lower with respect to at least one of
355-nm wavelength light, 532-nm wavelength light and 1,064-nm wavelength light.
